# FASCICULE DE BREVET EUROPEEN

(11) **EP 3 728 109 B1**
(45) Date de publication et mention de la délivrance du brevet: **13.10.2021**
(21) Numéro de dépôt: 18833953.5
(22) Date de dépôt: 17.12.2018
(51) Int. Cl.: B81C 1/00, H01L 21/78, B23K 26/53

(54) **PROCEDE DE REALISATION DE DISPOSITIFS SEMI-CONDUCTEURS ET DE CHEMINS DE DECOUPE**
VERFAHREN ZUR HERSTELLUNG VON HALBLEITERBAUELEMENTEN UND VEREINZELUNGSLINIEN
PROCESS FOR PRODUCING SEMICONDUCTOR DEVICES AND DICING LANES

(30) Priorité: 22.12.2017 FR 1763160
(43) Date de publication de la demande: 28.10.2020
(73) Titulaire: Commissariat à l'énergie atomique et aux énergies alternatives, 75015 Paris (FR); SAFRAN, 75015 Paris (FR)
(72) Inventeur: COLIN, Mikaël, 38000 GRENOBLE (FR); BERTHELOT, Audrey, 38330 SAINT-ISMIER (FR)
(74) Mandataire: Brevalex
(86) Numéro de dépôt international: PCT/FR2018/053318
(87) Numéro de publication internationale: WO 2019/122641

(56) Documents cités:
- US-A1- 2016 379 884
- Wikipedia: "Stepper", , 15 décembre 2017 (2017-12-15), XP055513223, Extrait de l'Internet: URL:https://en.wikipedia.org/w/index.php?t itle=Stepper&oldid=815465534 [extrait le 2018-10-08]
- KUMAGAI M ET AL: "Advanced Dicing Technology for Semiconductor Wafer-Stealth Dicing", IEEE TRANSACTIONS ON SEMICONDUCTOR MANUFACTURING, IEEE SERVICE CENTER, PISCATAWAY, NJ, US, vol. 20, no. 3, 1 août 2007 (2007-08-01), pages 259-265, XP011189520, ISSN: 0894-6507, DOI: 10.1109/TSM.2007.901849

## Description

### DOMAINE TECHNIQUE ET ART ANTÉRIEUR

L'invention concerne le domaine de la réalisation collective de dispositifs semi-conducteurs, ou puces, notamment de type MEMS (microsystèmes électromécaniques) et/ou NEMS (nanosystèmes électromécaniques) sur des substrats, ou wafers, par exemple de type bulk (massif) ou semi-conducteur sur isolant tel que le SOI (« Silicon On Insulator », ou silicium sur isolant) ou le BSOI (« Bonded Silicon On Insulator », silicium collé sur isolant).

De manière générale, les substrats ont des dimensions standardisées (4", 8", 12"...) et une épaisseur de quelques centaines de micromètres. L'une des principales étapes subies par les substrats lors de la réalisation de dispositifs semi-conducteurs dans ces substrats, après les étapes de fabrication collective des dispositifs en salle blanche (dépôts, gravures, dopages, etc.), consiste à les découper de façon à séparer les dispositifs les uns des autres et obtenir ainsi des puces indépendantes les unes des autres. De manière générale, les dispositifs obtenus après cette découpe présentent des dimensions extérieures pouvant être micrométriques, millimétriques, voire centimétriques.

Il existe différentes techniques pour réaliser cette découpe de substrat.

Une première de ces techniques consiste à scier le substrat avec une scie circulaire diamantée. Cette technique de découpe présente de nombreux avantages. Elle est relativement rapide (une seule passe de la scie par trait de découpe) et permet de réaliser des traits de découpe même si la hauteur du substrat varie le long du chemin de découpe ou s'il existe des zones métallisées sur ce chemin. Elle permet en particulier de découper un substrat sur toute sa longueur lors d'une seule passe de la scie, en passant à la fois par des régions au niveau desquelles des dispositifs sont réalisés et par les bords du substrat sur lesquels aucun dispositif n'est réalisé.

Cependant, ce type de découpe à la scie nécessite un moyen de refroidissement et d'évacuation des résidus de découpe générés. Ces besoins sont traditionnellement assurés par des jets d'eau à haute pression, rendant cette technique de découpe inappropriée pour la découpe de substrats sur lesquels les dispositifs ne sont pas protégés, par exemple par capotage WLP (« Wafer Level Packaging », ou encapsulation à l'échelle du substrat), compte tenu des risques de casse et/ou de « sticking » (collage d'éléments mobiles des dispositifs) engendrés par ces jets d'eau à haute pression. Enfin, la découpe de substrats à la scie permet de ne réaliser que des traits de découpe rectilignes traversant de part en part le substrat.

Une autre technique de découpe consiste à utiliser un laser découpant le substrat par ablation. L'utilisation d'un laser permet de contourner certains des inconvénients inhérents à la découpe par scie. En premier lieu, elle permet de réaliser des traits de découpe autres que des traits rectilignes. De plus, elle ne requiert aucun moyen de refroidissement. Il existe néanmoins un risque de contamination du substrat découpé du fait du re-dépôt, sur le substrat découpé, de particules engendrées par la découpe au laser. Cette technique n'est donc pas non plus adaptée à la découpe de substrat comportant des dispositifs mobiles non protégés.

Il existe également une technique particulière de découpe laser, appelée « stealth dicing », ou découpe laser par amorphisation du silicium, qui permet de supprimer le risque de contamination par re-dépôt de particules, caractéristique de la découpe laser par ablation. Le substrat à découper, sur lequel les dispositifs ont été réalisés par la mise en œuvre d'étapes de dépôt, photolithographie, gravure, etc., est placé sur un film étirable. Ensuite, un faisceau laser est utilisé pour modifier localement, au point de focalisation du faisceau, la structure cristalline du semi-conducteur du substrat à découper. Le semi-conducteur illuminé devenant localement amorphe dans un environnement cristallin, une concentration de contrainte apparait à cet endroit et se relaxe par microfissuration. Le long d'un chemin de découpe, plusieurs passes du faisceau laser, à différentes profondeurs du substrat, permettent de former des lignes de fragilisation, ou lignes de fissuration, sur toute l'épaisseur du substrat. Après avoir réalisé toutes les lignes de fragilisation souhaitées dans le substrat, le film étirable sur lequel est disposé le substrat est étiré de façon isotrope, ce qui étire également le substrat. Cet étirement permet de créer des espaces de quelques centaines de microns au niveau des lignes de fragilisation entre les dispositifs de sorte à ce qu'ils puissent être ensuite prélevés. Cet étirement permet, le cas échéant, de compléter la découpe par laser dans des endroits où cette découpe ne serait pas complète, par clivage. US 2016/379884 A1 concerne un procédé de découpage d'une tranche, notamment un procédé de séparation d'une pluralité de zones de bord de tranche. Selon ce document, une couche de résine photosensible est structurée par exposition, à travers d'un masque de lithographie, à une source de lumière telle qu'une lumière ultraviolette. Un plasma attaque la plaquette le long des ouvertures dans la couche de résine photosensible pour définir des lignes de découpe. Les lignes de découpe sont gravées complètement à travers la plaquette afin de séparer les « dies » et une pluralité de zones de bord de la plaquette.

Pour un substrat SOI (« Silicon On Insulator » ou silicium sur isolant) comprenant des dispositifs MEMS et/ou NEMS dont les éléments, notamment les éléments mobiles, sont réalisés dans la couche active, ou couche superficielle, de silicium du substrat, les chemins de découpe peuvent être gravés dans la couche active en même temps que les éléments des dispositifs, en incluant ces chemins de découpe dans le motif du masque de gravure utilisé pour former les éléments des dispositifs. Cela forme à travers la couche active de semi-conducteur des accès utilisables par le faisceau laser pour atteindre plus facilement la couche support, ou couche poignée, du substrat et modifier sa structure cristalline le long des chemins de découpe.

Etant donné que les dimensions critiques (dimensions minimales des éléments les constituant) des dispositifs notamment MEMS et/ou NEMS (de l'ordre du micromètre et du nanomètre respectivement) sont généralement inférieures aux dimensions limites atteignables par les masques de gravure, un équipement de photolithographie appelé « stepper », ou dispositif de photolithographie pas-à-pas, est généralement utilisé pour l'étape d'insolation UV de la résine photosensible, préalable à la gravure, lors de la réalisation des éléments des dispositifs. A la différence des équipements d'insolation classique avec lesquels l'ensemble de la surface du substrat est simultanément insolée à l'aide d'un seul masque de gravure, ou photomasque, recouvrant, soit directement soit en champ proche, toute la surface du substrat, l'insolation par un dispositif de type «stepper» fait appel à un masque de gravure particulier, appelé réticule, qui comporte un motif élémentaire correspondant aux éléments d'un ou plusieurs dispositifs et aux chemins de découpe de ce ou ces dispositifs. L'insolation de ce réticule est répétée plusieurs fois sur la surface du substrat, à différents endroits du substrat. Classiquement, un réticule comporte les motifs de quelques dispositifs jusqu'à quelques milliers de dispositifs. La réalisation de motifs jusqu'aux bords du substrat avec un tel équipement est à éviter car un dispositif réalisé à cheval sur le bord du substrat ne peut pas être intègre et risque de générer une contamination du fait de la possible réalisation de parties mobiles sans ancrage. Ainsi, une photolithographie pas-à-pas doit être réalisée en champ non débordant, les bords du substrat n'étant pas insolés par cette étape de photolithographie. Les chemins de découpe réalisés dans la couche active ne peuvent donc pas être réalisés jusqu'aux bords du substrat.

Cette précaution de ne pas réaliser un dispositif comprenant des éléments suspendus aux bords du substrat est également valable pour une photolithographie de l'ensemble de la surface du substrat réalisée à l'aide d'un seul masque de gravure recouvrant toute la surface du substrat.

Le fait qu'il ne soit pas possible de réaliser les chemins de découpe jusqu'aux bords du substrat n'est pas problématique lorsque le semi-conducteur du substrat n'est pas à la fois épais et fortement dopé. Par exemple, pour des dispositifs semi-conducteurs réalisés dans un substrat SOI comprenant un empilement formé d'une couche active, ou couche superficielle, de silicium dopé d'épaisseur égale à environ 60 µm, d'un diélectrique enterré (BOX) de SiO₂ d'épaisseur égale à environ 2 µm et d'une couche support de silicium d'épaisseur égale à environ 725 µm, les chemins de découpe sont réalisés par gravure DRIE (« Deep Reactive Ion Etching », ou gravure ionique réactive profonde) autour des dispositifs, et des lignes de fragilisation sont réalisées ensuite par irradiation laser dans la couche support au travers de ces chemins de découpe. Au niveau des bords du substrat, seules les lignes de fragilisation sont formées, sans chemin de découpe. Compte tenu de la faible épaisseur de la couche active de silicium, une énergie suffisante du faisceau laser atteint la couche support, ce qui rend possible, au niveau des bords du substrat, la réalisation de lignes de fragilisation dans la couche support et dans la couche active. La séparation des dispositifs obtenus est dans ce cas bonne et conforme aux chemins de découpe et aux lignes de fragilisation réalisés.

Par contre, le fait qu'il ne soit pas possible de réaliser les chemins de découpe jusqu'aux bords du substrat devient problématique pour découper du semi-conducteur fortement dopé et épais, comme par exemple lorsque les éléments des dispositifs sont réalisés au sein de deux couches actives de semi-conducteur dopé superposées et disposées au-dessus de la couche support du substrat, ou bien encore au sein d'une seule couche active épaisse. En effet, le taux de transmission du faisceau laser chute rapidement avec le niveau de dopage et l'épaisseur totale du semi-conducteur dopé à traverser. A titre d'exemple, le taux de transmission d'un faisceau laser à travers une épaisseur de 60 µm de silicium dopé P (Bore) à environ 5.10¹⁸ at/cm³ est d'environ 70 %. Ce taux de transmission est seulement de 40 % lorsque l'épaisseur de ce même semi-conducteur est de 120 µm. Une telle épaisseur peut correspondre à l'épaisseur totale des deux couches actives dans lesquelles les éléments des dispositifs sont réalisés. Par exemple, pour des dispositifs réalisés dans un substrat SOI comprenant un empilement formé d'une première couche active de silicium dopé d'épaisseur égale à environ 60 µm dans laquelle sont réalisés une partie des éléments des dispositifs, d'un premier diélectrique enterré de SiO₂ d'épaisseur égale à environ 2 µm, d'une deuxième couche active de silicium dopé d'épaisseur égale à environ 60 µm dans laquelle sont réalisés le reste des éléments des dispositifs, d'un deuxième diélectrique enterrée de SiO₂ d'épaisseur égale à environ 2µm et d'une couche support de silicium d'épaisseur égale à environ 725 µm, les lignes de fragilisation réalisées au niveau des bords du substrat ne peuvent pas être formées dans toute l'épaisseur de la couche support en raison de l'absence des chemins de découpe sur les bords du substrat et de l'épaisseur de semi-conducteur des couches actives à traverser par le faisceau laser pour atteindre la couche support. Dans ce cas, la séparation des dispositifs obtenue après avoir étiré le film étirable sur lequel se trouve le substrat est bonne et conforme aux chemins de découpe dans les portions du substrats au niveau desquelles les chemins de découpe sont réalisés, mais pas au niveau des bords du substrat où des lignes de fracture se forment de façon non contrôlée lors de la phase d'expansion du film étirable. Ces lignes de fracture non contrôlées ne sont pas souhaitables dans la mesure où elles induisent un risque important de défaillance des dispositifs (casse, collage des éléments, etc.) lorsqu'elles surviennent car ces fractures sont assimilables à un choc violent subi par les dispositifs.

### EXPOSÉ DE L'INVENTION

Un but de la présente invention est de proposer un procédé de réalisation de dispositifs semi-conducteurs ne présentant pas les inconvénients des procédés de l'art antérieur précédemment décrits, c'est-à-dire dans lequel une séparation des dispositifs par découpe de type « stealth dicing » peut être mise en œuvre quels que soit le dopage et l'épaisseur de la ou des couches du substrat dans lequel les dispositifs sont réalisés, et cela sans formation de lignes de fracture non contrôlées aux bords du substrat lors de la séparation des dispositifs.

Pour cela, la présente invention propose un procédé de réalisation de dispositifs semi-conducteurs dans un substrat, comportant au moins la mise en œuvre des étapes suivantes :
- photolithographie d'un motif d'un réticule sur une partie d'une face principale du substrat, définissant au moins des premiers éléments d'au moins un des dispositifs semi-conducteurs dans le substrat, une insolation du motif du réticule étant répétée plusieurs fois sur la face principale du substrat pour définir les premiers éléments de l'ensemble des dispositifs semi-conducteurs,
- photolithographie d'un motif d'un masque de gravure sur l'ensemble de la face principale du substrat,
- gravure des motifs photolithographiés sur la face principale du substrat dans une partie de l'épaisseur du substrat,
   dans lequel des premiers chemins de découpe entourant les dispositifs semi-conducteurs sont inclus dans le motif du masque de gravure et/ou dans le motif du réticule, et l'étape de photolithographie du motif du masque de gravure sur l'ensemble de la face principale du substrat définit des deuxièmes chemins de découpe définis par des lignes prédéterminées de fracture des bords du substrat,
   et comportant en outre la mise en œuvre d'une étape d'irradiation du substrat par faisceau laser au travers des premiers et deuxièmes chemins de découpe, formant dans le substrat des lignes de fragilisation, ou lignes de fissuration, sous les premiers et deuxièmes chemins de découpe.

Ce procédé propose de faire appel aux deux techniques existantes de photolithographie pour réaliser tous les chemins de découpe nécessaires à une bonne séparation des dispositifs semi-conducteurs sans risque de les endommager.

La photolithographie du motif du réticule permettant de définir les premiers éléments des dispositifs semi-conducteurs est ainsi mise en œuvre avec un équipement de photolithographie de type pas-à-pas, ou « stepper », ce qui rend ce procédé compatible avec la réalisation d'éléments des dispositifs semi-conducteur de très faibles dimensions.

L'autre photolithographie réalisée avec le masque de gravure en contact ou en champ proche avec le substrat, et qui est mise en œuvre avec une seule étape d'insolation sur toute la surface du substrat, rend possible la réalisation de deuxièmes chemins de découpe au niveau des bords du substrat. Ainsi, les lignes de fragilisation formées ensuite par irradiation laser du substrat sont réalisées sous les premiers chemins de découpe mais également sous ces deuxièmes chemins de découpe. Lors de la séparation des dispositifs semi-conducteurs, des lignes de fracture se forment donc de manière contrôlée en suivant les lignes de fragilisation réalisées. Ce contrôle des lignes de fracture obtenues à la séparation des dispositifs semi-conducteurs est également permis par le fait que les deuxièmes chemins de découpe et les lignes de fragilisation formées sous les deuxièmes chemins de découpe sont définis en fonction des lignes prédéterminées de fracture des bords du substrat, c'est-à-dire des lignes où le substrat se fracture en l'absence de lignes de fragilisation lors d'une séparation des dispositifs semi-conducteurs.

Ainsi, le risque de fracture non contrôlée du substrat lors de la séparation des dispositifs semi-conducteurs est supprimé même lorsque le substrat est épais et comporte un dopage important.

Ce procédé ne présente pas les inconvénients rencontrés avec les procédé de découpe par sciage ou par ablation laser, et est donc compatible avec la réalisation de dispositifs non encapsulés par un capot.

Dans le procédé décrit ci-dessus, l'étape de photolithographie faisant appel au réticule définissant les premiers éléments des dispositifs semi-conducteurs peut être mise en œuvre avant ou après l'étape de photolithographie faisant appel au masque de gravure définissant les deuxièmes chemins de découpe.

Le procédé peut comporter en outre, avant la mise en œuvre des étapes de photolithographie, une étape d'identification des lignes prédéterminées de fracture des bords du substrat par modélisation ou par calcul analytique ou par observation de lignes de fracture obtenues dans un autre substrat identique au dit substrat et dans lequel les deuxièmes chemins de découpe n'ont pas été réalisés.

Les deuxièmes chemins de découpe peuvent être localisés au moins sur les lignes prédéterminées de fracture des bords du substrat. Dans ce cas, lors de la séparation des dispositifs semi-conducteurs, les lignes de fracture se forment de manière contrôlée au niveau des bords du substrat et correspondent au moins aux lignes prédéterminées de fracture des bords du substrat.

Il est également possible que les deuxièmes chemins de découpe soient localisés non pas exactement le long des lignes prédéterminées de fracture des bords du substrat, mais à proximité des lignes prédéterminées de fracture des bords du substrat, le long de directions sensiblement proches des lignes prédéterminées de fractures des bords du substrat, ce qui permet de guider les lignes de fracture selon ces deuxièmes chemins de découpe.

Les lignes prédéterminées de fracture des bords du substrat peuvent s'étendre depuis des coins formés par les premiers chemins de découpe jusqu'aux bords du substrat. Cette configuration correspond aux lignes prédéterminées de fracture obtenues lorsque le substrat est étiré de manière isotrope lors de la séparation des dispositifs réalisés sur ce substrat.

Les dispositifs semi-conducteurs peuvent être de type MEMS et/ou NEMS. Dans ce cas, les éléments des dispositifs semi-conducteurs correspondent aux éléments fixes et/ou mobiles des dispositifs.

Selon un premier exemple de réalisation, le procédé peut être tel que :
- le substrat comporte une couche support, une première couche active de semi-conducteur, et une première couche diélectrique disposée entre la couche support et la première couche active,
- les premiers éléments des dispositifs semi-conducteurs et les premiers et deuxièmes chemins de découpe sont gravés dans la première couche active, et
- les lignes de fragilisation sont formées dans la couche support.

Dans ce premier exemple de réalisation, le substrat correspond à un substrat de type semi-conducteur sur isolant, par exemple SOI. En outre, dans ce premier exemple de réalisation, la face principale du substrat sur laquelle les étapes de photolithographie sont mises en œuvre correspond à la face principale de la première couche active opposée à celle se trouvant en contact avec la première couche diélectrique. Au cours de la réalisation de tels dispositifs semi-conducteur, il est possible que d'autres étapes, par exemple de photolithographie et de gravure et/ou de dépôt de matériau, soient mises en œuvre au niveau de la face arrière du substrat, c'est-à-dire l'autre face principale du substrat qui correspond à la face principale de la couche support opposée à celle se trouvant en contact avec la première couche diélectrique.

L'épaisseur de la première couche active peut être supérieure ou égale à environ 120 µm.

Selon un deuxième exemple de réalisation, le procédé peut être tel que :
- le substrat comporte une couche support, une première couche active de semi-conducteur, une première couche diélectrique disposée entre la couche support et la première couche active, une deuxième couche diélectrique telle que la première couche active soit disposée entre les première et deuxième couches diélectriques, et une deuxième couche active de semi-conducteur telle que la deuxième couche diélectrique soit disposée entre les première et deuxième couches actives,
- les premiers éléments des dispositifs semi-conducteurs et les premiers et deuxièmes chemins de découpe sont gravés au moins dans la deuxième couche active, et
- les lignes de fragilisation sont formées dans la couche support et dans la première couche active.

Dans ce deuxième exemple de réalisation, le substrat comporte deux couches actives qui peuvent servir à la réalisation des éléments des dispositifs semi-conducteurs. Le substrat peut correspondre à un substrat SOI sur lequel ont été reportées la deuxième couche active et la deuxième couche diélectrique. L'utilisation combinée des premiers et deuxièmes chemins de découpe et de l'irradiation laser avec un tel substrat permet de s'affranchir des contraintes liées au dopage et à l'épaisseur totale des couches actives.

Dans ce deuxième exemple de réalisation, le procédé peut comporter en outre, avant la mise en œuvre des étapes de photolithographie, la mise en œuvre des étapes suivantes :
- réalisation, à partir d'un empilement comprenant la couche support, la première couche diélectrique et la première couche active, de deuxièmes éléments des dispositifs semi-conducteurs dans la première couche active par photolithographie et gravure,
- report et solidarisation de la deuxième couche diélectrique et de la deuxième couche active contre la première couche active.

L'épaisseur totale des première et deuxième couches actives peut être supérieure ou égale à environ 120 µm.

Selon une réalisation avantageuse, le motif du masque de gravure peut inclure un identifiant distinct pour chacun des dispositifs semi-conducteurs.

Le motif du masque de gravure peut inclure une partie des motifs des dispositifs semi-conducteurs. Par exemple, cette partie des motifs des dispositifs semi-conducteurs peut correspondre à au moins un élément ne nécessitant pas une résolution importante ni un positionnement très précis (par exemple ne nécessitant pas une précision inférieure à 1 ou 2 microns) par rapport au reste du motif des dispositifs semi-conducteurs défini par le réticule. Un tel élément peut correspondre par exemple à une ouverture vers un niveau inférieur, servant par exemple à réaliser une prise de contact.

Le procédé peut être tel que :
- entre les étapes de gravure des motifs photolithographiés et l'étape d'irradiation du substrat par faisceau laser, le substrat est disposé sur un film étirable, et
- après la mise en œuvre de l'étape d'irradiation du substrat, le film étirable est étiré tel que les dispositifs semi-conducteurs soient séparés les uns des autres au niveau des premiers chemins de découpe et que différentes parties du substrat formant les bords du substrat soient séparées les unes des autres au niveau des deuxièmes chemins de découpe.

De manière avantageuse, le film étirable peut être étiré de manière isotrope.

Le film étirable peut comporter un polymère et présenter des propriétés adhésives, et, après l'étirement du film étirable, le film étirable peut être insolé par un rayonnement UV depuis une face opposée à celle sur laquelle se trouvent les dispositifs semi-conducteurs pour supprimer les propriétés adhésives du film étirable.

Les premiers chemins de découpe peuvent former des cadres de forme sensiblement rectangulaire autour des dispositifs semi-conducteurs.

Le matériau semi-conducteur du substrat est avantageusement du silicium. Toutefois, le procédé peut être mis en œuvre pour d'autres matériaux semi-conducteurs tels que du SiGe, du Ge, de l'AsGa, etc.

### BRÈVE DESCRIPTION DES DESSINS

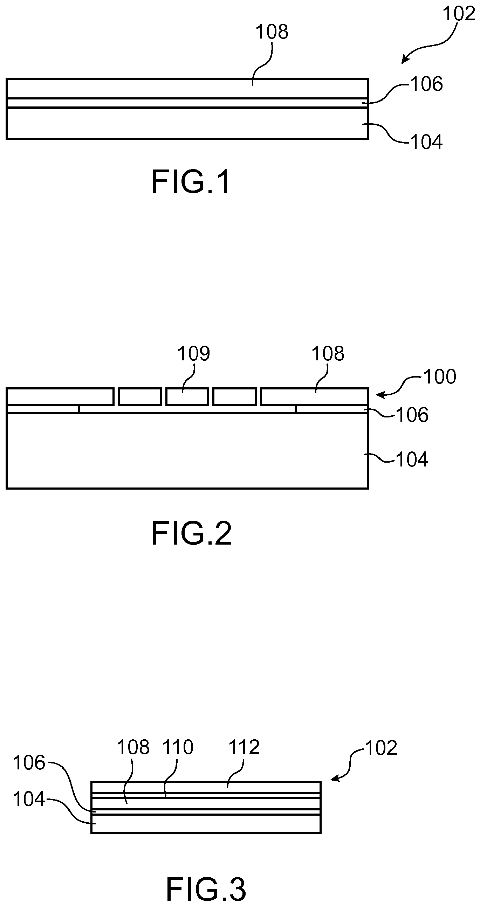

La présente invention sera mieux comprise à la lecture de la description d'exemples de réalisation donnés à titre purement indicatif et nullement limitatif en faisant référence aux dessins annexés sur lesquels les figures 1 à 9 illustrent un procédé de réalisation de dispositifs semi-conducteurs, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

Un procédé de réalisation de dispositifs semi-conducteurs 100 dans un substrat 102 selon un mode de réalisation particulier est décrit ci-dessous en lien avec les figures 1 à 9. Dans ce mode de réalisation particulier, les dispositifs semi-conducteurs 100 réalisés sont de type MEMS et/ou NEMS.

Comme représenté sur la figure 1, le substrat 102 à partir duquel les dispositifs semi-conducteurs 100 sont réalisés, sous forme de puces, comporte une couche support 104. La couche support 104 comporte par exemple au moins un semi-conducteur, ici du silicium, et a une épaisseur égale à plusieurs centaines de microns, par exemple supérieure ou égale à environ 500 µm.

Le substrat 102 comporte également une première couche diélectrique, ou isolante, 106 disposée sur la couche support 104. L'épaisseur de la première couche diélectrique 106 est par exemple comprise entre environ 0,1 µm et 5 µm, ici égale à environ 2 µm, et comporte par exemple du SiO₂.

Le substrat 102 comporte également une première couche active 108 de semi-conducteur disposée sur la première couche diélectrique 106 et dans laquelle une partie des éléments mobiles et/ou fixes des dispositifs 100 est destinée à être réalisée. La première couche active 108 comporte par exemple du silicium et a une épaisseur qui est par exemple comprise entre environ 5 µm et 200 µm. Dans le mode de réalisation particulier décrit ici, la première couche active 108 a une épaisseur égale à environ 60 µm. De plus, le semi-conducteur de la première couche active 108 est ici dopé, par exemple avec des atomes de bore ou de phosphore et avec une concentration par exemple comprise entre environ 10¹³ at/cm³ et 10²⁰ at/cm³, ici égale à environ 5.10¹⁸ at/cm³.

Des éléments mobiles et/ou fixes 109 des dispositifs 100 sont réalisés dans la première couche active 108 par la mise en œuvre d'étapes de photolithographie et gravure. La figure 2 représente schématiquement la structure obtenue à l'issue de ces étapes pour un des dispositifs 100. Des portions de la première couche diélectrique 106 se trouvant sous certains des éléments 109 correspondant à des éléments mobiles sont gravées pour libérer ces éléments 109.

Une deuxième couche diélectrique, ou isolante, 110 et une deuxième couche active 112 sont ensuite reportées et solidarisées sur la première couche active 108. Ce report peut être réalisé à partir d'un autre substrat SOI comportant une couche support, une couche diélectrique enterrée et une couche superficielle de semi-conducteur. La couche superficielle de cet autre substrat SOI, destinée à former la deuxième couche active 112, est en partie oxydée, formant la deuxième couche diélectrique 110 en surface de cette couche superficielle. Un collage est ensuite réalisé entre la deuxième couche diélectrique 110 et la première couche active 108. La couche support et la couche diélectrique enterrée de cet autre substrat SOI sont ensuite retirées successivement pour aboutir à l'empilement représenté sur la figure 3. En variante, au lieu d'utiliser un autre substrat SOI, il est possible de faire appel à un substrat massif, ou bulk, formant la deuxième couche active 112, préalablement oxydé, cette partie oxydée formant la deuxième couche diélectrique 110. Un collage est ensuite réalisé entre la deuxième couche diélectrique 110 et la première couche active 108, formant l'empilement représenté sur la figure 3. Si nécessaire, l'épaisseur de la deuxième couche active 112 peut être réduite par rodage et/ou polissage.

L'épaisseur de la deuxième couche diélectrique 110 est par exemple comprise entre environ 0,1 µm et 5 µm, ici égale à environ 2 µm, et comporte par exemple du SiO₂. L'épaisseur et le matériau de la deuxième couche diélectrique 110 peuvent être similaires à l'épaisseur et au matériau de la première couche diélectrique 106.

La deuxième couche active 112 comporte par exemple du silicium et a une épaisseur qui est par exemple comprise entre environ 5 µm et 200 µm. Dans le mode de réalisation particulier décrit ici, la première couche active 108 a une épaisseur égale à environ 60 µm. Comme la première couche active 108, le semi-conducteur de la deuxième couche active 112 est ici dopé, par exemple avec des atomes de bore ou de phosphore et avec une concentration par exemple comprise entre environ 10¹³ at/cm³ et 10²⁰ at/cm³, ici égale à environ 5.10¹⁸ at/cm³.

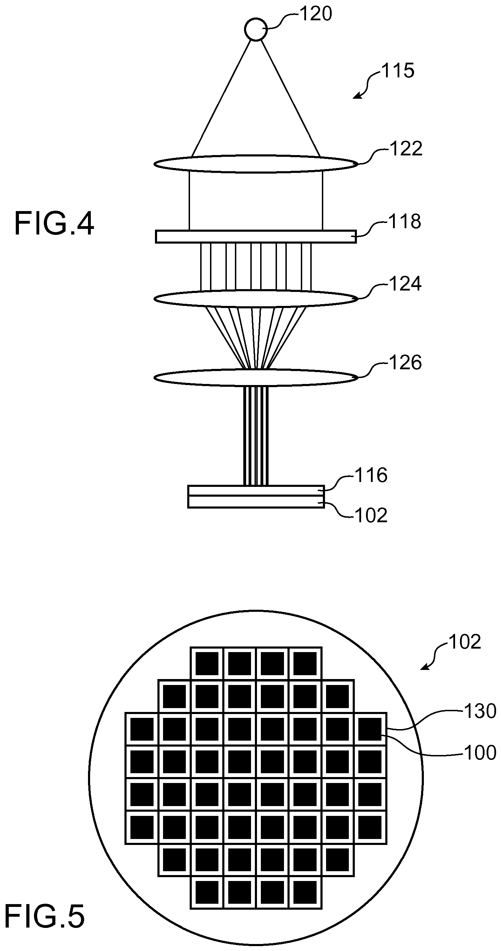

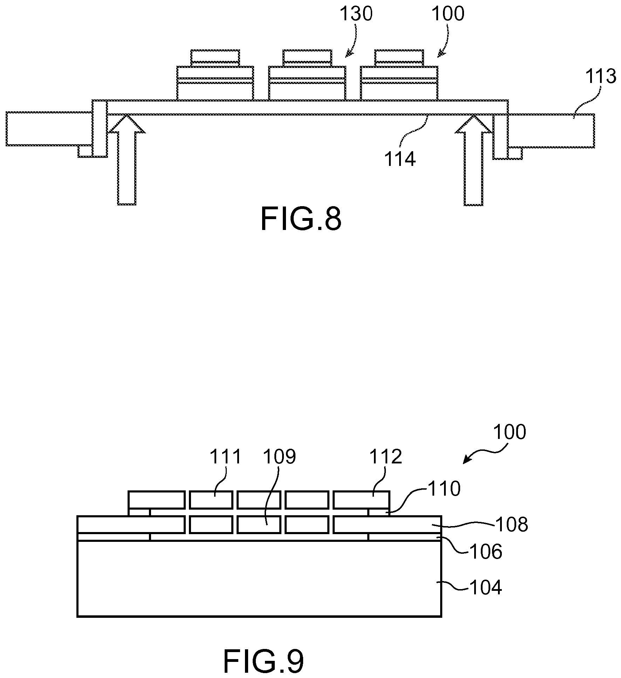

Une première étape de photolithographie est mise en œuvre dans la deuxième couche active 112 avec un équipement de photolithographie pas-à-pas, ou de type « stepper ». La figure 4 représente schématiquement le principe de fonctionnement d'un tel équipement 115 de photolithographie pas-à-pas. Lors de cette première étape de photolithographie, une résine photosensible 116 est déposée sur le substrat 102, plus précisément sur la face principale du substrat 102 qui correspond à la face avant du substrat 102 et qui est formée par la deuxième couche active 112 (ou par la première couche active 108 lorsque le substrat 102 ne comporte qu'une seule couche active). Le motif d'un réticule 118 est ensuite transféré dans une partie de la couche de résine 116 se trouvant sur une partie de la deuxième couche active 112 (ou de la première couche active 108 lorsque le substrat 102 ne comporte qu'une seule couche active). Ce motif permet de définir des éléments 111 d'autres dispositifs 100 (visibles sur la figure 9). Le transfert du motif du réticule 118 dans la couche de résine 116 est obtenu via une source lumineuse 120 émettant une lumière qui est ensuite collimatée sur le réticule 118 par un premier élément optique 122. Les rayons de lumière traversant le réticule 118 sont ensuite réduits par un deuxième élément optique 124 puis collimatés par un troisième élément optique 126 sur la partie de la deuxième couche active 112 dans laquelle les éléments définis par le réticule 118 sont destinés à être réalisés. Chacun des premier, deuxième et troisième éléments optiques 122, 124, 126 est par exemple formé d'une ou plusieurs lentilles.

Dans le mode de réalisation particulier décrit ici, la résine photosensible utilisée est une résine positive, c'est-à-dire pour laquelle la partie exposée à la lumière correspond à celle qui sera retirée ultérieurement lors du développement de la résine. En variante, l'utilisation d'une résine négative est possible.

L'utilisation d'un équipement de type stepper pour réaliser cette première étape de photolithographie permet de définir les différents éléments mobiles et/ou fixes des dispositifs 100 avec des dimensions relativement faibles, par exemple de l'ordre du micron ou de quelques microns.

Ce transfert du motif du réticule 118 dans la couche de résine 116 est répété plusieurs fois sur la face principale du substrat 102 afin de définir les éléments de tous les dispositifs 100, par exemple en déplaçant le substrat 102 par rapport aux éléments de l'équipement 115 permettant de focaliser les rayons lumineux à l'endroit souhaitée sur le substrat 102.

Dans le mode de réalisation particulier décrit ici, le motif du réticule 118 inclut également des premiers chemins de découpe 130 entourant le ou chacun des dispositifs 100 dont les éléments sont définis par le motif du réticule 118. Chacun des motifs correspondant à un des dispositifs 100 est ici entouré par un premier chemin de découpe 130 qui permettra par la suite de séparer les dispositifs 100 les uns des autres. Les premiers chemins de découpe 130 ont une largeur bien supérieure à celle des lignes définissant les éléments mobiles et/ou fixes des dispositifs 100, par exemple égale à environ 300 µm.

La figure 5 représente une vue de dessus de la face principale du substrat 102 dans lequel des éléments des dispositifs 100, représentés chacun sous la forme d'un rectangle, et des premiers chemins de découpe 130 entourant les dispositifs 100 ont été insolés dans la couche de résine 116 à ce stade du procédé. Dans cet exemple de réalisation, les premiers chemins de découpe 130 forment des cadres de forme sensiblement rectangulaire autour des dispositifs 100.

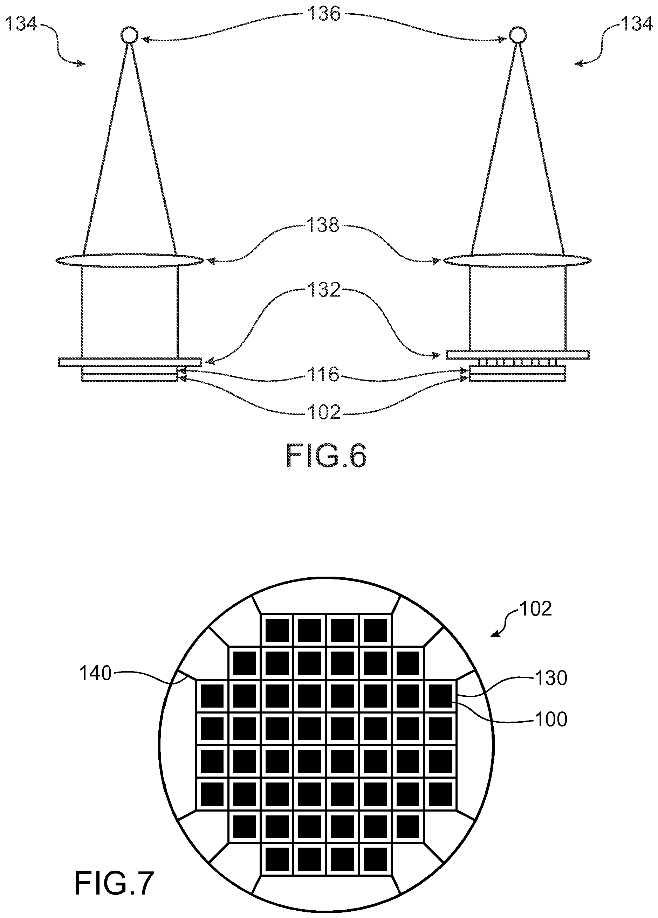

Une deuxième étape de photolithographie est ensuite mise en œuvre avec un équipement de photolithographie conventionnel, c'est-à-dire dans lequel un masque de gravure 132, ou photomasque, est disposé en contact ou en champ proche de la couche de résine 116 et tel que son motif permette d'insoler l'ensemble de la face principale de la deuxième couche active 112. La figure 6 représente schématiquement un tel équipement, référencé 134, avec sur le schéma de gauche la configuration dans laquelle le masque de gravure 132 est disposé en contact avec la couche de résine 116, et sur le schéma de droite la configuration dans laquelle le masque de gravure 132 est disposé en champ proche de la couche de résine 116, c'est-à-dire espacé de la couche de résine 116. Le transfert du motif du masque de gravure 132 dans la couche de résine 116 est obtenu par l'intermédiaire d'une source lumineuse 136 émettant une lumière qui est ensuite collimatée sur le masque de gravure 132 par un élément optique 138 formé par exemple d'une ou plusieurs lentilles.

Le motif du masque de gravure 132 correspond à des deuxièmes chemins de découpe 140 localisés sur des lignes prédéterminées de fracture des bords du substrat 102. Ces lignes de fracture correspondent aux endroits où le substrat 102 est destiné à se fracturer lors de la séparation des dispositifs 100 les uns des autres. Ces lignes de fracture sont qualifiées de prédéterminées car leurs caractéristiques (nombre, emplacement, etc.) sont connues à l'avance. Elles peuvent être prédéterminées par exemple en les ayant identifiées au préalable par modélisation, ou par calcul analytique, ou bien encore en ayant observé les lignes de fracture obtenues naturellement dans un autre substrat identique au substrat 102, c'est-à-dire en ayant séparé de la même manière les dispositifs 100 réalisés sur cet autre substrat mais sans avoir réalisé les deuxièmes chemins de découpe 140 dans le substrat.

Dans le mode de réalisation décrit ici, les dispositifs 100 sont destinés à être séparés les uns des autres grâce à l'utilisation d'un film étirable 114 (visible sur la figure 8) sur lequel le substrat 102 est collé, en réalisant un étirement isotrope de ce film 114. Dans ce cas, les lignes prédéterminées de fracture s'étendent depuis des coins formés par les premiers chemins de découpe 130 jusqu'aux bords du substrat 102. En variante, il est toutefois possible que cet étirement ne soit pas isotrope, ou encore que les dispositifs 100 soient séparés les uns des autres par une étape différente d'un étirement.

Les deuxièmes chemins de découpe 140 ont une largeur proche ou égale à celle des premiers chemins de découpe 130, par exemple égale à environ 300 µm dans l'exemple de réalisation décrit ici.

Dans le mode de réalisation décrit ici, le nombre de deuxièmes chemins de découpe 140 est limité au nombre de lignes de fracture qui apparaîtraient naturellement en l'absence de ces deuxièmes chemins de découpe lors de l'étirement isotrope du substrat 102. Cela permet d'éviter la réalisation de chemins de découpe non nécessaires qui pourraient fragiliser le substrat 102 depuis la réalisation de ces chemins de découpe jusqu'à la séparation des dispositifs 100.

En variante, il est possible de réaliser des deuxièmes chemins de découpe 140 supplémentaires qui ne sont pas localisés sur les lignes prédéterminées de fracture. Dans ce cas, lors de la séparation des dispositifs 100, les bords du substrat 102 se séparent en plusieurs parties en suivant les deuxièmes chemins de découpe 140 localisés sur les lignes prédéterminées de fracture ainsi que les deuxièmes chemins de découpe 140 supplémentaires qui ne sont pas localisés sur les lignes prédéterminées de fracture.

La figure 7 représente une vue de dessus du substrat 102 à ce stade du procédé, c'est-à-dire comprenant, en plus des éléments des dispositifs 100 et des premiers chemins de découpe 130, les deuxièmes chemins de découpe 140 insolés dans la couche de résine 116.

En considérant le motif global formé par les dispositifs 100 et les premiers chemins de découpe 130, les deuxièmes chemins de découpe 140 partent des coins formant des angles saillants de ce motif, jusqu'aux bords du substrat 102, et sont chacun alignés avec une droite passant par le centre du substrat 102 et le coin depuis lequel s'étend ce deuxième chemin de découpe 140. Sur l'exemple de la figure 7, les coins du motif formé par les dispositifs 100 et les premiers chemins de découpe 130 depuis lesquels s'étendent les deuxièmes chemins de découpe 140 correspondent à ceux formés par les premiers chemins de découpe 130 qui n'entourent qu'un seul dispositif 100.

Les motifs insolés dans la couche de résine 116 lors des deux étapes de photolithographie décrites précédemment, à savoir les éléments des dispositifs 100 autres que ceux précédemment réalisés dans la première couche active 108, les premiers chemins de découpe 130 et les deuxièmes chemins de découpe 140, sont ensuite gravés à travers toute l'épaisseur de la deuxième couche active 112. Certaines portions de la deuxième couche diélectrique 110 sont également gravées, ce qui permet notamment de libérer les éléments mobiles des dispositifs 100 destinés à être formés dans la deuxième couche active 112.

Le substrat 102 est ensuite disposé sur le film étirable 114. Le film étirable 114 comporte un matériau adhésif, par exemple un polymère, permettant le maintien du substrat 102 sur celui. De plus, le matériau adhésif du film étirable 114 a ici pour propriété d'être sensible à une exposition de rayons UV tel que les zones du film étirable 114 exposées à ces rayons UV perdent leur propriété adhésive. Cette exposition aux rayons UV sera mise en œuvre ultérieurement afin de pouvoir détacher les dispositifs 100 réalisés.

Comme cela est visible sur la figure 8, les bords du film étirable 114 sont solidaires d'un élément de maintien 113, par exemple en forme d'anneau, qui sert à l'étirement isotrope du film étirable 114.

Une étape d'irradiation du substrat 102 par faisceau laser (de type « stealth dicing ») est mise en œuvre au travers des premiers et deuxièmes chemins de découpe 130, 140, ce qui permet de former dans la couche support 104 et dans la première couche active 106 des lignes de fragilisation sous les premiers et deuxièmes chemins de découpe 130, 140. Le faisceau laser utilisé modifie localement, au point de focalisation du faisceau, la structure cristalline du semi-conducteur de la couche support 104 et de la première couche active 106. Le semi-conducteur illuminé devenant localement amorphe dans un contexte environnant de structure cristalline, une concentration de contrainte apparait à cet endroit et se relaxe par microfissuration. Plusieurs passes du faisceau laser, à différentes profondeurs, sont mises en œuvre pour former les lignes de fragilisation à la fois dans la couche support 104 et dans la première couche active 106.

Le film étirable 114 est ensuite étiré afin de séparer les dispositifs 100 les uns des autres au niveau des premiers chemins de découpe 130 et des lignes de fragilisation se trouvant sous les premiers chemins de découpe 130 (figure 8, sur laquelle seuls trois dispositifs 100 sont représentés). Cette opération est par exemple mise en œuvre en appliquant une force au niveau des bords de la face arrière du film 114 (force représentée symboliquement par des flèches sur la figure 8), le long des bords intérieurs de l'élément de maintien 113, c'est-à-dire le long d'un cercle de rayon inférieur au rayon du cercle formé par les bords intérieurs de l'élément de maintien 113 et supérieur au rayon du substrat 102. Par exemple, il est possible d'utiliser un élément en forme d'anneau ou de tube et de déplacer vers le haut cet élément, c'est-à-dire suivant la direction correspondant aux flèches représentées sur la figure 8, en gardant les autres éléments (élément de maintien 113, film 114 et substrat 102) à la même hauteur durant ce déplacement. Etant donné que la face arrière du film 114 contre laquelle cet élément est en appui n'est pas adhésive, le film 114 glisse localement au niveau des zones de contact avec cet élément qui applique la force sur cette face arrière du film 114. Du fait que les bords du film 114 sont solidaires de l'élément de maintien 113 qui est fixe, la force appliquée sur la face arrière du film 114 permet d'obtenir un étirement isotrope du substrat 102. La conséquence de cet étirement est que les différentes parties du substrat 102 qui correspondent chacune à un des dispositifs 100 se détachent les unes des autres.

Les parties du substrat 102 se trouvant au niveau des bords et dans lesquelles aucun dispositif 100 n'est réalisé se détachent également les unes des autres au niveau des deuxièmes chemins de découpe 140 et des lignes de fragilisation localisées sous les deuxièmes chemins de découpe 140.

Les dispositifs 100 sont ensuite détachés du film étirable 114 de préférence en ayant préalablement réalisé une insolation par rayonnement UV du film étirable 114 depuis sa face arrière, c'est-à-dire la face opposée à celle sur laquelle se trouvent les dispositifs 100, afin de supprimer les propriétés d'adhérence du film 114 vis-à-vis des dispositifs 100.

La figure 9 représente schématiquement un des dispositifs 100 obtenus à l'issu de ce procédé. Des éléments du dispositif 100 réalisés dans la deuxième couche active 112 sont visibles sur cette figure, et portent la référence 111.

Dans le mode de réalisation particulier décrit ci-dessus, les motifs des premiers chemins de découpe 130 sont inclus dans le motif du réticule 118 servant également à la réalisation des éléments 111 des dispositifs 100 destinés à être réalisés dans la deuxième couche active 112. Selon une variante, il est possible que le motif des premiers chemins de découpe 130 ne fasse pas partie du motif du réticule 118 mais fasse partie du motif du masque de gravure 132 avec lequel les deuxièmes chemins de découpe 140 sont définis. Cette variante est possible en raison de la largeur importante des premiers chemins de découpe 130, par exemple supérieure à environ 100 µm, qui rend possible leur réalisation à partir d'un masque de gravure destiné à être insolé sur toute la surface du substrat 102. Selon une autre variante, les motifs des premiers chemins de découpe 130 peuvent être répartis dans le motif du réticule 118 et dans le motif du masque de gravure 132.

Dans le mode de réalisation particulier décrit ci-dessus, les dispositifs 100 comportent des éléments fixes et/ou mobiles répartis dans deux couches actives 108, 112 superposées. En variante, il est possible que le substrat 102 dans lequel les dispositifs 100 sont réalisés comporte une seule couche active dans laquelle sont formés tous les éléments des dispositifs 100. Les premiers et deuxièmes chemins de découpe 130, 140 sont donc également réalisés dans cette unique couche active, et les lignes de fragilisation sont formées uniquement dans la couche support 104. Le procédé décrit ci-dessus est très avantageux lorsque cette unique couche active comporte par exemple du semi-conducteur dopé et une épaisseur importante, par exemple égale ou supérieure à environ 120 µm.

Quel que soit le nombre de couches actives que comporte le substrat 102, une variante avantageuse du procédé consiste à utiliser le masque de gravure 132 servant à la réalisation des deuxièmes chemins de découpe 140 pour réaliser une identification des dispositifs 100, en incluant un identifiant distinct pour chacun des dispositifs 100 dans le motif du masque de gravure 132. En effet, une telle identification distincte pour chacun des dispositifs 100 n'est pas réalisable lorsque seule une photolithographie pas-à-pas (« stepper ») est mise en œuvre pour réaliser les dispositifs 100 (du fait que le motif du réticule 118 est répété plusieurs fois pour définir tous les dispositifs 100, ce qui n'est pas compatible avec l'association d'un identifiant distinct pour chacun des dispositifs 100). Cet identifiant peut correspondre par exemple à un numéro propre à chacun des dispositifs 100.

En outre, dans le procédé précédemment décrit, les premiers chemins de découpe 130 sont réalisés sous la forme de lignes droites formant des cadres rectangulaires entourant les dispositifs 100. En variante, et du fait que ces premiers chemins de découpe 130 sont réalisés par photolithographie, il est possible que les premiers chemins de découpe 130 ne forment pas des rectangles autour des dispositifs 100, mais des formes différentes choisies en fonction de la forme des puces désirant être obtenues.

## Revendications

1. Procédé de réalisation de dispositifs semi-conducteurs (100) dans un substrat (102), comportant au moins la mise en œuvre des étapes suivantes :
- photolithographie d'un motif d'un réticule (118) sur une partie d'une face principale du substrat (102), définissant au moins des premiers éléments (111) d'au moins un des dispositifs semi-conducteurs (100) dans le substrat (102), une insolation du motif du réticule (118) étant répétée plusieurs fois sur la face principale du substrat (102) pour définir les premiers éléments (111) de l'ensemble des dispositifs semi-conducteurs (100),
- photolithographie d'un motif d'un masque de gravure (132) sur l'ensemble de la face principale du substrat (102),
- gravure des motifs photolithographiés sur la face principale du substrat (102) dans une partie de l'épaisseur du substrat (102),
dans lequel des premiers chemins de découpe (130) entourant les dispositifs semi-conducteurs (100) sont inclus dans le motif du masque de gravure (132) et/ou dans le motif du réticule (118), et l'étape de photolithographie du motif du masque de gravure (132) sur l'ensemble de la face principale du substrat (102) définit des deuxièmes chemins de découpe (140) définis par des lignes prédéterminées de fracture des bords du substrat (102),
et comportant en outre la mise en œuvre d'une étape d'irradiation du substrat (102) par faisceau laser au travers des premiers et deuxièmes chemins de découpe (130, 140), formant dans le substrat (102) des lignes de fragilisation sous les premiers et deuxièmes chemins de découpe (130, 140).

2. Procédé selon la revendication 1, comportant en outre, avant la mise en œuvre des étapes de photolithographie, une étape d'identification des lignes prédéterminées de fracture des bords du substrat (102) par modélisation ou par calcul analytique ou par observation de lignes de fracture obtenues dans un autre substrat identique au dit substrat (102) et dans lequel les deuxièmes chemins de découpe (140) n'ont pas été réalisés.

3. Procédé selon l'une des revendications précédentes, dans lequel les deuxièmes chemins de découpe (140) sont localisés au moins sur les lignes prédéterminées de fracture des bords du substrat (102).

4. Procédé selon l'une des revendications précédentes, dans lequel les lignes prédéterminées de fracture des bords du substrat (102) s'étendent depuis des coins formés par les premiers chemins de découpe (130) jusqu'aux bords du substrat (102).

5. Procédé selon l'une des revendications précédentes, dans lequel les dispositifs semi-conducteurs (100) sont de type MEMS et/ou NEMS.

6. Procédé selon l'une des revendications précédentes, dans lequel :
- le substrat (102) comporte une couche support (104), une première couche active (108) de semi-conducteur, et une première couche diélectrique (106) disposée entre la couche support (104) et la première couche active (108),
- les premiers éléments (111) des dispositifs semi-conducteurs (100) et les premiers et deuxièmes chemins de découpe (130, 140) sont gravés dans la première couche active (108), et
- les lignes de fragilisation sont formées dans la couche support (104).

7. Procédé selon la revendication 6, dans lequel l'épaisseur de la première couche active (108) est supérieure ou égale à environ 120 µm.

8. Procédé selon l'une des revendications 1 à 5, dans lequel :
- le substrat (102) comporte une couche support (104), une première couche active (108) de semi-conducteur, une première couche diélectrique (106) disposée entre la couche support (104) et la première couche active (108), une deuxième couche diélectrique (110) telle que la première couche active (108) soit disposée entre les première et deuxième couches diélectriques (106, 110), et une deuxième couche active (112) de semi-conducteur telle que la deuxième couche diélectrique (110) soit disposée entre les première et deuxième couches actives (108, 112),
- les premiers éléments (111) des dispositifs semi-conducteurs (100) et les premiers et deuxièmes chemins de découpe (130, 140) sont gravés au moins dans la deuxième couche active (112), et
- les lignes de fragilisation sont formées dans la couche support (104) et dans la première couche active (108).

9. Procédé selon la revendication 8, comportant en outre, avant la mise en œuvre des étapes de photolithographie, la mise en œuvre des étapes suivantes :
- réalisation, à partir d'un empilement comprenant la couche support (104), la première couche diélectrique (106) et la première couche active (108), de deuxièmes éléments (109) des dispositifs semi-conducteurs (100) dans la première couche active (108) par photolithographie et gravure,
- report et solidarisation de la deuxième couche diélectrique (110) et de la deuxième couche active (112) contre la première couche active (108).

10. Procédé selon l'une des revendications 8 ou 9, dans lequel l'épaisseur totale des première et deuxième couches actives (108, 112) est supérieure ou égale à environ 120 µm.

11. Procédé selon l'une des revendications précédentes, dans lequel le motif du masque de gravure (132) inclut un identifiant distinct pour chacun des dispositifs semi-conducteurs (100).

12. Procédé selon l'une des revendications précédentes, dans lequel le motif du masque de gravure (132) inclut une partie des motifs des dispositifs semi-conducteurs (100).

13. Procédé selon l'une des revendications précédentes, dans lequel :
- entre les étapes de gravure des motifs photolithographiés et l'étape d'irradiation du substrat (102) par faisceau laser, le substrat (102) est disposé sur un film étirable (114), et
- après la mise en œuvre de l'étape d'irradiation du substrat (102), le film étirable (114) est étiré tel que les dispositifs semi-conducteurs (100) soient séparés les uns des autres au niveau des premiers chemins de découpe (130) et que différentes parties du substrat (102) formant les bords du substrat (102) soient séparées les unes des autres au niveau des deuxièmes chemins de découpe (140).

14. Procédé selon la revendication 13, dans lequel le film étirable (114) est étiré de manière isotrope.

15. Procédé selon l'une des revendications 13 ou 14, dans lequel le film étirable (114) comporte un polymère et présente des propriétés adhésives, et dans lequel, après l'étirement du film étirable (114), le film étirable (114) est insolé par un rayonnement UV depuis une face opposée à celle sur laquelle se trouvent les dispositifs semi-conducteurs (100).

16. Procédé selon l'une des revendications précédentes, dans lequel les premiers chemins de découpe (130) forment des cadres de forme sensiblement rectangulaire autour des dispositifs semi-conducteurs (100).

## Patentansprüche

1. Verfahren zur Herstellung von Halbleitervorrichtungen (100) in einem Substrat (102), das zumindest die Ausführung der folgenden Schritte umfasst:
- Photolithographieren eines Musters eines Retikels (118) auf einem Teil einer Hauptfläche des Substrats (102), das zumindest erste Elemente (111) von zumindest einer der Halbleitervorrichtungen (100) in dem Substrat (102) definiert, wobei die Belichtung des Musters des Retikels (118) mehrere Male auf der Hauptfläche des Substrats (102) wiederholt wird, um die ersten Elemente (111) von sämtlichen Halbleitervorrichtungen (100) zu definieren,
- Photolithographieren eines Musters einer Ätzmaske (132) auf der gesamten Hauptfläche des Substrats (102),
- Ätzen der photolithographierten Muster auf der Hauptfläche des Substrats (102) in einem Teil der Dicke des Substrats (102),
wobei erste Schneidpfade (130), die die Halbleitervorrichtungen (100) umgeben, in dem Muster der Ätzmaske (132) und/oder in dem Muster des Retikels (118) enthalten sind, und der Schritt des Photolithographierens des Musters der Ätzmaske (132) auf der gesamten Hauptfläche des Substrats (102) zweite Schneidpfade (140) definiert, die durch Sollbruchlinien der Kanten des Substrats (102) definiert sind,
und ferner umfassend die Ausführung eines Schritts des Bestrahlens des Substrats (102) mit einem Laserstrahl durch die ersten und zweiten Schneidpfade (130, 140) hindurch, wodurch in dem Substrat (102) Versprödungslinien unter den ersten und zweiten Schneidpfaden (130, 140) gebildet werden.

2. Verfahren nach Anspruch 1, ferner umfassend vor der Ausführung der Schritte des Photolithographierens einen Schritt des Identifizierens von Sollbruchlinien der Kanten des Substrats (102) durch Modellierung oder durch analytische Berechnung oder durch Beobachtung von Bruchlinien, die in einem anderen Substrat erhalten werden, das mit dem Substrat (102) identisch ist und in dem die zweiten Schneidpfade (140) nicht hergestellt wurden.

3. Verfahren nach einem der vorhergehenden Ansprüche, wobei die zweiten Schneidpfade (140) zumindest auf den Sollbruchlinien der Kanten des Substrats (102) liegen.

4. Verfahren nach einem der vorhergehenden Ansprüche, wobei die Sollbruchlinien der Kanten des Substrats (102) von den durch die ersten Schneidpfade (130) gebildeten Ecken bis zu den Kanten des Substrats (102) verlaufen.

5. Verfahren nach einem der vorhergehenden Ansprüche, wobei die Halbleitervorrichtungen (100) MEMS und/oder NEMS sind.

6. Verfahren nach einem der vorhergehenden Ansprüche, wobei:
- das Substrat (102) eine Trägerschicht (104), eine erste aktive Halbleiter-Schicht (108) und eine erste dielektrische Schicht (106) umfasst, die zwischen der Trägerschicht (104) und der ersten aktiven Schicht (108) angeordnet ist,
- die ersten Elemente (111) der Halbleitervorrichtungen (100) und die ersten und die zweiten Schneidpfade (130, 140) in die erste aktive Schicht (108) geätzt werden, und
- die Versprödungslinien in der Trägerschicht (104) ausgebildet werden.

7. Verfahren nach Anspruch 6, wobei die Dicke der ersten aktiven Schicht (108) größer als oder gleich etwa 120 µm ist.

8. Verfahren nach einem der Ansprüche 1 bis 5, wobei:
- das Substrat (102) eine Trägerschicht (104), eine erste aktive Halbleiter-Schicht (108), eine erste dielektrische Schicht (106), die zwischen der Trägerschicht (104) und der ersten aktiven Schicht (108) angeordnet ist, eine zweite dielektrische Schicht (110), derart, dass die erste aktive Schicht (108) zwischen der ersten und zweiten dielektrischen Schicht (106, 110) angeordnet ist, und eine zweite aktive Halbleiter-Schicht (112), derart, dass die zweite dielektrische Schicht (110) zwischen der ersten und zweiten aktiven Schicht (108, 112) angeordnet ist, umfasst,
- die ersten Elemente (111) der Halbleitervorrichtungen (100) und die ersten und die weiten Schneidpfade (130, 140) zumindest in die zweite aktive Schicht (112) geätzt werden, und
- die Versprödungslinien in der Trägerschicht (104) und in der ersten aktiven Schicht (108) ausgebildet werden.

9. Verfahren nach Anspruch 8, ferner umfassend vor der Ausführung der Schritte des Photolithographierens die folgenden Schritte:
- Herstellen von zweiten Elementen (109) der Halbleitervorrichtungen (100) in der ersten aktiven Schicht (108) ausgehend von einem Stapel, der die Trägerschicht (104), die erste dielektrische Schicht (106) und die erste aktive Schicht (108) umfasst, durch Photolithographieren und Ätzen,
- Übertragen und Verbinden der zweiten dielektrischen Schicht (110) und der zweiten aktiven Schicht (112) mit der ersten aktiven Schicht (108).

10. Verfahren nach einem der Ansprüche 8 oder 9, wobei die Gesamtdicke der ersten und zweiten aktiven Schicht (108, 112) größer als oder gleich etwa 120 µm ist.

11. Verfahren nach einem der vorhergehenden Ansprüche, wobei das Muster der Ätzmaske (132) eine separate Kennung für jede der Halbleitervorrichtungen (100) enthält.

12. Verfahren nach einem der vorhergehenden Ansprüche, wobei das Muster der Ätzmaske (132) einen Teil der Muster der Halbleitervorrichtungen (100) enthält.

13. Verfahren nach einem der vorhergehenden Ansprüche, wobei:
- zwischen den Schritten des Ätzens der photolithographierten Muster und dem Schritt des Bestrahlens des Substrats (102) mit einem Laserstrahl das Substrat (102) auf einer Streckfolie (114) angeordnet wird, und
- nach dem Schritt des Bestrahlens des Substrats (102) die Streckfolie (114) so verstreckt wird, dass die Halbleitervorrichtungen (100) im Bereich der ersten Schneidpfade (130) voneinander getrennt werden und verschiedene Teile des Substrats (102), die die Kanten des Substrats (102) bilden, im Bereich der zweiten Schneidpfade (140) voneinander getrennt werden.

14. Verfahren nach Anspruch 13, wobei die Streckfolie (114) isotrop verstreckt wird.

15. Verfahren nach einem der Ansprüche 13 oder 14, wobei die Streckfolie (114) ein Polymer umfasst und Klebeeigenschaften aufweist, und wobei nach dem Verstrecken der Streckfolie (114) die Streckfolie (114) durch UV-Strahlung von einer Seite, die derjenigen gegenüberliegt, auf der sich die Halbleitervorrichtungen (100) befinden, belichtet wird.

16. Verfahren nach einem der vorhergehenden Ansprüche, wobei die ersten Schneidpfade (130) im Wesentlichen rechteckige Rahmen um die Halbleitervorrichtungen (100) herum bilden.

## Claims

1. Method for producing semiconductor devices (100) in a substrate (102), comprising at least the implementation of the following steps:
- photolithography of a pattern of a reticle (118) over a portion of a main face of the substrate (102), defining at least first elements (111) of at least one of the semiconductor devices (100) in the substrate (102), an exposure of the pattern of the reticle (118) being repeated a plurality of times over the main face of the substrate (102) in order to define the first elements (111) of all the semiconductor devices (100),
- photolithography of a pattern of an etch mask (132) over all of the main face of the substrate (102),
- etching of the photolithography patterns over the main face of the substrate (102) into one portion of the thickness of the substrate (102),
wherein first dicing lanes (130) around the semiconductor devices (100) are included in the pattern of the etch mask (132) and/or in the pattern of the reticle (118), and the step of photolithography of the pattern of the etch mask (132) over all of the main face of the substrate (102) defines second dicing lanes (140) defined by predetermined fracture lines of the edges of the substrate (102),
and further comprising the implementation of a step of irradiating the substrate (102) with a laser beam through the first and second dicing lanes (130, 140), forming lines of weakness in the substrate (102), under the first and second dicing lanes (130, 140).

2. Method according to claim 1, further comprising, before implementing the photolithography steps, a step of identifying the predetermined fracture lines of the edges of the substrate (102) by modelling or by analytic calculation or by observation of fracture lines obtained in another substrate identical to said substrate (102) and in which the second dicing lanes (140) have not been produced.

3. Method according to one of the preceding claims, wherein the second dicing lanes (140) are located at least on the predetermined fracture lines of the edges of the substrate (102).

4. Method according to one of the preceding claims, wherein the predetermined fracture lines of the edges of the substrate (102) extend from the corners formed by the first dicing lanes (130) to the edges of the substrate (102).

5. Method according to one of the preceding claims, wherein the semiconductor devices (100) are of MEMS and/or NEMS type.

6. Method according to one of the preceding claims, wherein:
- the substrate (102) comprises a support layer (104), a first active semiconductor layer (108), and a first dielectric layer (106) disposed between the support layer (104) and the first active layer (108),
- the first elements (111) of the semiconductor devices (100) and the first and second dicing lanes (130, 140) are etched in the first active layer (108), and
- the lines of weakness are formed in the support layer (104).

7. Method according to claim 6, wherein the thickness of the first active layer (108) is greater than or equal to approximately 120 µm.

8. Method according to one of claims 1 to 5, wherein:
- the substrate (102) comprises a support layer (104), a first active semiconductor layer (108), a first dielectric layer (106) disposed between the support layer (104) and the first active layer (108), a second dielectric layer (110) such that the first active layer (108) is disposed between the first and second dielectric layers (106, 110), and a second active semiconductor layer (112) such that the second dielectric layer (110) is disposed between the first and second active layers (108, 112),
- the first elements (111) of the semiconductor devices (100) and the first and second dicing lanes (130, 140) are etched at least in the second active layer (112), and
- the lines of weakness are formed in the support layer (104) and in the first active layer (108).

9. Method according to claim 8, further comprising, before implementing the photolithography steps, the implementation of the following steps:
- producing, from a stack comprising the support layer (104), the first dielectric layer (106) and the first active layer (108), second elements (109) of the semiconductor devices (100) in the first active layer (108) by photolithography and etching,
- transferring and securing the second dielectric layer (110) and the second active layer (112) against the first active layer (108).

10. Method according to one of claims 8 or 9, wherein the total thickness of the first and second active layers (108, 112) is greater than or equal to approximately 120 µm.

11. Method according to one of the preceding claims, wherein the pattern of the etch mask (132) includes a separate identifier for each of the semiconductor devices (100).

12. Method according to one of the preceding claims, wherein the pattern of the etch mask (132) includes a portion of the patterns of the semiconductor devices (100).

13. Method according to one of the preceding claims, wherein:
- between the steps of etching the photolithography patterns and the step of irradiating the substrate (102) with a laser beam, the substrate (102) is disposed on a stretch film (114), and
- after implementing the step of irradiating the substrate (102), the stretch film (114) is stretched so that the semiconductor devices (100) are separated from each other at the first dicing lanes (130) and so that different portions of the substrate (102) forming the edges of the substrate (102) are separated from each other at the second dicing lanes (140).

14. Method according to claim 13, wherein the stretch film (114) is stretched isotropically.

15. Method according to one of claims 13 or 14, wherein the stretch film (114) comprises a polymer and has adhesive properties, and wherein, after stretching of the stretch film (114), the stretch film (114) is exposed to UV radiation from a face opposite that on which the semiconductor devices (100) are located.

16. Method according to one of the preceding claims, wherein the first dicing lanes (130) form frames of substantially rectangular shape around the semiconductor devices (100).
